# EUROPÄISCHE PATENTSCHRIFT

(11) **EP 3 218 097 B1**
(45) Veröffentlichungstag und Bekanntmachung des Hinweises auf die Patenterteilung: **19.09.2018**
(21) Anmeldenummer: 15795127.8
(22) Anmeldetag: 03.11.2015
(51) Int. Cl.: B01J 8/18, C01B 33/027, C01B 33/029

(54) **VERFAHRN ZUR MONTAGE EINES WIRBELSCHICHTREAKTORS ZUR HERSTELLUNG VON POLYKRISTALLINEM SILICIUMGRANULAT**
METHOD FOR ASSEMBLING A FLUIDIZED BED REACTOR FOR PRODUCING POLYCRYSTALLINE SILICON GRANULES
PROCÉDÉ DE MONTAGE D'UN RÉACTEUR À LIT FLUIDISÉ POUR LA FABRICATION DE GRANULAT DE SILICIUM POLYCRISTALLIN

(30) Priorität: 10.11.2014 DE 102014222865
(43) Veröffentlichungstag der Anmeldung: 20.09.2017
(73) Patentinhaber: Wacker Chemie AG, 81737 München (DE)
(72) Erfinder: WECKESSER, Dirk, 84561 Mehring (DE); FORSTPOINTNER, Gerhard, 84556 Kastl (DE); HERTLEIN, Harald, 84489 Burghausen (DE)
(74) Vertreter: Potten, Holger
(86) Internationale Anmeldenummer: PCT/EP2015/075507
(87) Internationale Veröffentlichungsnummer: WO 2016/074978

(56) Entgegenhaltungen:
- US-A- 4 207 360
- US-A- 4 786 477
- US-A1- 2008 006 617
- US-A1- 2010 044 342
- US-A1- 2011 206 866
- US-A1- 2012 269 686

## Beschreibung

Die Erfindung betrifft ein Verfahren zur Montage eines Wirbelschichtreaktors zur Herstellung von polykristallinem Siliciumgranulat.

Polykristallines Siliciumgranulat wird in einem Wirbelschicht- bzw. Fließbettreaktor produziert. Dies geschieht durch Fluidisierung von Siliciumpartikeln mittels einer Gasströmung in einer Wirbelschicht, wobei diese über eine Heizvorrichtung auf hohe Temperaturen aufgeheizt wird. Durch Zugabe eines siliciumhaltigen Reaktionsgases erfolgt eine Abscheidereaktion an der heißen Partikeloberfläche. Dabei scheidet sich elementares Silicium auf den Siliciumpartikeln ab und die einzelnen Partikel wachsen im Durchmesser an. Durch den regelmäßigen Abzug von angewachsenen Partikeln und Zugabe kleinerer Siliciumkeimpartikel kann das Verfahren kontinuierlich mit allen damit verbundenen Vorteilen betrieben werden. Als siliciumhaltiges Eduktgas sind Silicium-Halogenverbindungen (z.B. Chlorsilane oder Bromsilane), Monosilan (SiH4), sowie Mischungen dieser Gase mit Wasserstoff beschrieben.

US 4900411 A offenbart ein Verfahren zur Gewinnung hochreinen polykristallinen Siliciums durch Niederschlagung von Silicium auf hochreine Siliciumteilchen aus siliciumhaltigem Gas, wie Silan, Dichlorsilan, Trichlorsilan oder Tribromsilan, gekennzeichnet durch einen Reaktor mit einem fluidisierten Bett, in welches zusammen mit Siliciumimpfteilchen ein Reaktionsgas durch ein Einleitungsrohr eingeleitet wird, Mikrowellen zugeführt werden, um die fluidisierten Teilchen zu erhitzen, sodass sich darauf Polysilicium niederschlägt.

US 7029632 B2 offenbart einen Fließbettreaktor mit einer drucktragenden Hülle, einem inneren Reaktorrohr, das Wärmestrahlung transmittiert, einem Einlass für Siliciumpartikel, einem rohrförmigen Einlass zum Zuführen eines Reaktionsgases, der das Fließbett in eine Heizzone und eine darüber liegende Reaktionszone teilt, einer Gasverteilungseinrichtung für die Zufuhr eines Fluidisiergases in die Heizzone, einem Auslass für nicht abreagiertes Reaktionsgas, Fluidisiergas sowie die gas- oder dampfförmigen Produkte der Reaktion, einem Auslass für das Produkt, einer Heizvorrichtung sowie einer Energieversorgung für die Heizvorrichtung, wobei vorgeschlagen wird, dass die Heizvorrichtung eine Strahlungsquelle für Wärmestrahlung ist, die außerhalb des inneren Reaktorrohres und ohne direkten Kontakt zu diesem ringförmig um die Heizzone angeordnet ist und derart ausgebildet ist, dass sie mittels Wärmestrahlung die Siliciumteilchen in der Heizzone auf so eine Temperatur aufheizt, dass sich in der Reaktionszone die Reaktionstemperatur einstellt.
Heizzone und Reaktionszone sind vertikal getrennt. Dies ermöglicht es, das Fließbett auch mit anderen Heizmethoden als mit Mikrowellen zu beheizen, da es in der Heizzone zu keiner Wandabscheidung kommen kann, weil dort kein siliciumhaltiges Gas vorliegt. Es ist eine Wärmestrahlungsheizung mit flächigen Heizerelementen vorgesehen, die die Wärme gleichmäßig über den Umfang des Fließbettes und örtlich definiert einbringt.
Bei der Heizvorrichtung handelt es sich beispielsweise um Heizelemente aus dotiertem Silicium oder Graphit oder Siliciumcarbid, Quarzrohrstrahler, Keramikstrahler oder Metalldrahtstrahler. Insbesondere bevorzugt handelt es sich bei der Heizvorrichtung um ein mäanderförmig geschlitztes Rohr aus Graphit mit SiC-Oberflächenbeschichtung, das im Reaktor stehend oder hängend an den Elektrodenanschlüssen angeordnet ist.

US 4786477 A offenbart eine Vorrichtung zur Durchführung des Verfahrens, die einen Reaktor mit einem Gaseinleitungsrohr für das Reaktionsgasgemisch am unteren Ende, ein Gasauslassrohr am oberen Ende sowie ein Zuführungsrohr für die Siliciumimpfteilchen aufweist, dadurch gekennzeichnet, dass der aus Quarz bestehende Reaktor sich vertikalstehend auf der Mittellinie eines Wärmeerzeugers befindet, in welchem ein Abschirmungsschild gegen Mikrowellen im mittleren Teil installiert ist und der mit Mikrowellengeneratoren über Mikrowellenführungsrohren in Verbindung steht, wobei unterhalb des Reaktors eine Gasverteilerplatte und innerhalb jedes Mikrowellenführungsrohres eine Gasabsperrmembran angeordnet ist, und dass Kühlkanäle zwischen der Wand des Wärmeerzeugers und der äußeren Wand des Reaktors sowie in der Gasverteilungsplatte vorgesehen sind.

In einer Ausgestaltung der Vorrichtung nach US 4786477 A ragt der Gasauslass nach außen durch und ist in loser Form aufgesetzt, wobei eine Graphitdichtung an der Verbindungsstelle mit dem Quarzreaktor liegt. Die Graphitdichtung wird von einem Halter gehalten, der auf der Seite des Gasauslasses liegt und der von einer Feder in axialer Richtung beaufschlagt ist. Die Verbindung wird somit durch den Federdruck über den Halter auf den Quarzreaktor in dichtender Weise gehalten, selbst dann, wenn der Reaktor sich etwas bewegt.
Das obere Teil des Wärmeerzeugers, durch das das Gasauslassrohr nach außen ragt, wird durch eine PTFE-Dichtung und einen Halter gasdicht verschlossen.
Das Gaseinleitungsrohr ist mit dem unteren Ende des Wärmeerzeugers verbunden und eine Gasverteilungsplatte ist zwischen das Gaseinlassrohr und das untere Ende des Quarzreaktors eingefügt. Ein Kühlmittelweg ist in der Gasverteilungsplatte gebildet. Ein Auslassrohr für Teilchen ist mit dem unteren Teil des Quarzreaktors verbunden und erstreckt sich zu einem Siliciumsammelbehälter. Eine Graphitdichtung verhindert den Austritt von Reaktionsgas an der Stelle zwischen dem Quarzreaktor und dem Wärmeerzeuger.
In einer anderen Ausgestaltungsform der Vorrichtung ist das obere Ende des Quarzreaktors direkt mit dem Gasauslassrohr verbunden. Das untere Ende hat eine Gasdichtung, die verhindert, dass Reaktionsgas aus dem Wärmeerzeuger entweicht, d. h. es ist ein O-Ring aus Graphit als Dichtung zwischen dem Flansch des Wärmeerzeugers und dem Flansch des Quarzreaktors und der Gasverteilungsplatte eingefügt, damit völlige Gasdichtigkeit herrscht.

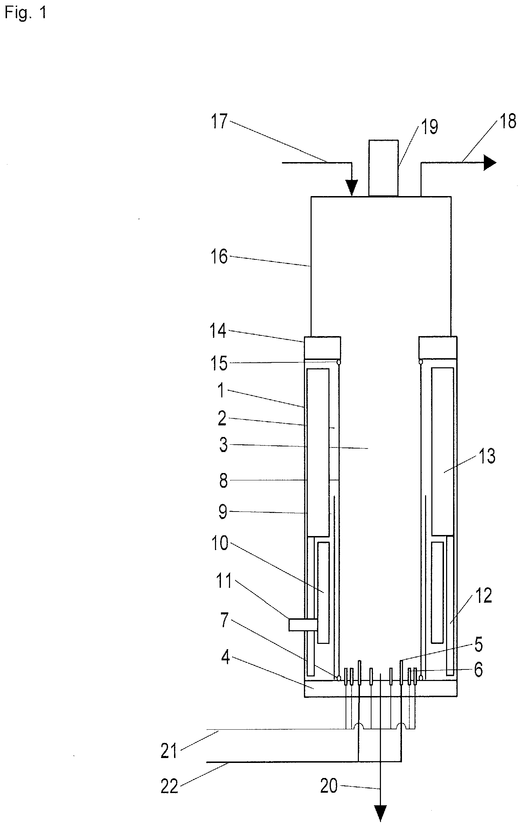

US 2010/044342 A1 und US4207360 A offenbaren Wirbelschichtreaktoren zur Herstellung von polykristallinem Siliciumgranulat. Diese Reaktoren ähneln den in Fig. 1 dargestellten Reaktor. keine der Schriften offenbaren allerdings die Reihenfolge des Zusammenbaus der Bauteile, aus denen diese Reaktoren aufgebaut sind.

US2012269686 beschreibt ein Verfahren zur Montage eines Wirbelschichtreaktors. In dem Verfahren wird der mehrteilige Reaktorrohr-Inliner erst in den einen oder die zwei Schussteile eingebaut. Dann wird die Bodenplatte bestückt mit Düsen, Elektroden und einem Heizer. Dann wird eines der mit dem ersten Reaktor-Inliner bestückten Schuss teile auf der Bodenplatte platziert und die Abdichtung von Reaktorrohr zur Bodenplatte herbeigeführt.

Es hat sich gezeigt, dass die Reihenfolge der Montage der einzelnen Bauteile eines Wirbelschichtreaktors einen erheblichen Einfluss auf dessen Funktionsfähigkeit hat. Ein wesentliches Problem stellt dabei die Gasdichtheit des Reaktionsraumes dar. Zudem kann es bei der Montage zu einer Beschädigung des Reaktorrohres kommen.

Aus der beschriebenen Problematik ergab sich die Aufgabenstellung der Erfindung.

Die Aufgabe wird gelöst durch ein Verfahren zur Montage eines Wirbelschichtreaktors für die Herstellung von polykristallinem Siliciumgranulat, umfassend nachfolgende Schritte in der angegebenen Reihenfolge:
- Bodenplatte (4) aufbauen und mit Gaszufuhrleitungen für Fluidisierungsgas (21) und Reaktionsgas (22) und Produktabzugsleitung (20) verbinden
- Bodenplatte (4) mit wenigstens einer Fluidisierungsgasdüse (6) und mit wenigstens einer Reaktionsgasdüse (5) bestücken
- Untere Reaktorrohrdichtung (7) in die Bodenplatte (4) einsetzen
- Reaktorrohr (8) auf untere Reaktorrohrdichtung (7) aufbauen
- Aufstellen des Reaktorschusses (1) mit Heizer (10), Elektroden (11) und Isolationsteile (12, 13) über dem Reaktorrohr (8)
- Obere Reaktorrohreinspannung (14) mit oberer Reaktorrohrdichtung (15) aufbauen
- Montage des Reaktorkopfes (16)
- Montage Seedzufuhreinrichtung (17) und Abgasrohrleitung (18).

Die Erfinder haben erkannt, dass eine Abweichung von der erfindungsgemäßen Montagereihenfolge dazu führen kann, dass das Reaktionsrohr beschädigt wird und dass der Reaktor im Reaktionsraum nicht gasdicht ist.

Außerdem ist es nicht möglich, Heizer und Isolationen zu montieren, wenn die äußere Hülle bereits aufgestellt ist. Eine erfolgreiche Montagereihenfolge ist gegeben, wenn das Reaktionsrohr nicht beschädigt wird, der Reaktor gasdicht ist und alle Heizer- und Isolationsteile ordnungsgemäß und funktionstüchtig angeordnet sind. Außerdem muss durch ausreichende Abstände zwischen stromzuführenden Bauteilen und Isolationen ein entsprechend ausreichender Isolationswiderstand gewährleistet werden.

Zunächst wird die Bodenplatte aufgebaut und mit den Gaszufuhrleitungen für Fluidisierungsgas (z. B. Wasserstoff) und Reaktionsgas (z. B. Trichlorsilan) verbunden.

Zudem wird die Bodenplatte mit der Produktabzugsleitung verbunden, mit der polykristallines Siliciumgranulat aus dem Reaktor abgeführt werden kann.

Dann wird die Bodenplatte mit den entsprechenden Düsen bestückt, zumindest mit jeweils einer Fluidisierungsgasdüse und einer Reaktionsgasdüse.

Anschließend wird die untere Reaktorrohrdichtung in der Bodenplatte eingesetzt. Auf dieser wird das Reaktorrohr aufgebaut.

Dann wird der Reaktorschuss mit darin montierten Heizer, Elektroden und Isolationsteilen über dem Reaktorrohr aufgestellt.

Anschließend wird die obere Reaktorrohreinspannung mit der oberen Reaktorrohrdichtung aufgebaut.

Auf der oberen Reaktorrohreinspannung mit der oberen Reaktorrohrdichtung wird der Reaktorkopf montiert.

Schließlich werden Seedzufuhreinrichtung und Abgasrohrleitung montiert.

Vorzugweise werden Messeinrichtungen am Reaktorkopf montiert. Mit den Messeinrichtungen werden vorzugweise der Kopfreaktordruck sowie mittels eines Pyrometer durch ein Schauglas die Wirbelschicht-Temperatur gemessen. In einer Ausführungsform erfolgt eine Kameraaufzeichnung durch ein Schauglas.

In einer Ausführungsform wird ein zylinderförmiges Bauteil um das aufgebaute Reaktorrohr gestülpt, bevor der Reaktorschuss aufgestellt wird. In diesem Fall wird der Reaktorschuss mit darin montierten Heizer, Elektroden und Isolationsteilen über dem zylinderförmigen Bauteil aufgestellt.

Im montierten Zustand befindet sich das zylinderförmige Bauteil zwischen Reaktorrohr und Heizvorrichtung.

Das zylinderförmige Bauteil weist auf seiner Mantelfläche Öffnungen auf, wobei wenigstens 5% und höchstens 95% der Mantelfläche offen sind. Unter dem Merkmal, dass wenigstens 5% und höchstens 95% der Mantelfläche des zylinderförmigen Bauteils offen sind, ist zu verstehen, dass ein Verhältnis von freier Fläche (Summe der Öffnungsflächen) zur gesamten Mantelfläche des Bauteils 5-95% beträgt.

Vorzugweise beträgt dieses Verhältnis 40-70%, besonders bevorzugt 45-60%.

Bei den Öffnungen kann es sich um Schlitze, Ausschnitte, Maschen, Bohrungen usw. handeln.

Das Bauteil kann beispielsweise die Form eines zylindrischen Gitters haben.

Nach oben oder nach unten oder in beide Richtungen (Grund- und Deckfläche des Zylinders) ist das Bauteil vorzugweise geöffnet. Das erleichtert die Demontage des Reaktors.

Bei der Heizvorrichtung kann es sich um einen mäanderförmigen Heizer oder um eine Vielzahl von Heizelementen bzw. Heizleisten handeln.

Vorzugweise besteht die Heizvorrichtung aus mehreren konzentrisch um das Innen-Reaktorrohr angeordneten Heizelementen. Zwischen den Heizelementen und dem Innen-Reaktorrohr befindet sich in diesem Fall vorzugweise das Bauteil, das ebenfalls konzentrisch um das Innen-Reaktorrohr angeordnet ist.

Vorzugweise besteht das Bauteil aus einem gut wärmeleitenden Material. Die Heizenergie wird durch Wärmestrahlung und Wärmeleitung auf das Bauelement übertragen und bringt dieses zum Glühen.

Auch ist es bevorzugt, ein Bauteil einzusetzen, das aus einem Material besteht, das für die Strahlungsenergie der Heizvorrichtung durchlässig ist.

Vorzugweise befinden sich die Heizelemente in Öffnungen der Mantelfläche des Bauteils. Bei den Öffnungen kann es sich um Ausschnitte handeln, in denen sich die Heizleisten befinden.

Vorzugweise umfasst das Bauteil ein Material ausgewählt aus der Gruppe bestehend aus Graphit, CFC, Silicium, SiC und Quarzglas. Das Bauteil kann aus einem oder mehreren der genannten Materialien bestehen. Ebenso kann das Bauteil mit einem oder mehreren der genannten Materialien beschichtet sein.

Es hat sich überraschenderweise gezeigt, dass die Verwendung eines zuvor genannten Bauteils zwischen Heizvorrichtung und Reaktorrohr neben einer Vergleichmäßigung der Temperatur auch geeignet ist, die Heizvorrichtung während des Ausfahrens des Reaktors zu schützen.

Im Stand der Technik kam es infolge des Auseinanderbrechens des Reaktorrohrs auch zu Beschädigungen an den Heizelementen. Dies kann durch die vorliegende Erfindung vermieden werden. Das Bauteil ist gegenüber brechenden Teilen des Reaktorrohres unempfindlich und kann wiederverwendet werden.

Zudem liegt anders als im Stand der Technik kein Strahlungsschild vor, da das Bauteil Öffnungen aufweist und damit der Energieeintrag in die Wirbelschicht auf eine wirtschaftlichere Art und Weise erfolgt.

Die Montage des Wirbelschichtreaktors sollte nach dem zuvor erläuterten erfindungsgemäßen Verfahren erfolgen, da die darin definierte Montagereihenfolge sicherstellt, dass die Montage fehlerfrei und ohne Beschädigungen erfolgt und der Wirbelschichtreaktor gasdicht ist.

Vorzugweise umfasst der Wirbelschichtreaktor auch ein zuvor beschriebenes zylinderförmiges Bauteil (9) zwischen Reaktorrohr (8) und Heizer (10), das auf seiner Mantelfläche Öffnungen aufweist, wobei wenigstens 5% und höchstens 95% der Mantelfläche offen sind.

Vorzugweise umfasst der Wirbelschichtreaktor weiterhin Messeinrichtungen (19), die am Reaktorkopf (16) montiert sind. Mit den Messeinrichtungen werden vorzugweise der Kopfreaktordruck sowie mittels eines Pyrometer durch ein Schauglas die Wirbelschicht-Temperatur gemessen. In einer Ausführungsform erfolgt eine Kameraaufzeichnung durch ein Schauglas.

Das Reaktorrohr besteht vorzugweise aus einem hochreinen und hochtemperaturbeständigen Werkstoff, insbesondere aus Quarzglas, SiN oder SiC, wobei das Reaktorrohr auch wenigstens auf der reaktionszugewandten Seite CVD-beschichtet sein kann.

Die erfindungsgemäße Montagevorschrift stellt eine ausreichende Dichtheit des Reaktionsbereiches gegenüber dem Zwischenmantel und eine ausreichende Dichtheit der drucktragenden Hülle (Reaktorschuss) gegenüber der Umgebung sicher. Es ist sichergestellt, dass bei der Montage das Reaktorrohr unter normalen Umständen nicht beschädigt wird. Isolationsbauteile, Elektroden und Heizer lassen sich korrekt befestigen. Ein ausreichend hoher Isolationswiderstand kann gewährleistet werden.

Nach der Montage des Wirbelschichtreaktors kann mit diesem polykristallines Siliciumgranulat hergestellt werden, indem Siliciumkeimpartikeln mittels einer Gasströmung in einer mittels einer Heizvorrichtung aufgeheizten Wirbelschicht fluidisiert werden, wobei durch Zugabe eines siliciumhaltigen Reaktionsgases polykristallines Silicium an den heißen Siliciumkeimpartikeloberflächen abgeschieden wird, wodurch das polykristalline Siliciumgranulat entsteht.

Vorzugweise wird das entstehende polykristalline Siliciumgranulat aus dem Wirbelschichtreaktor abgeführt.

Vorzugweise wird das Verfahren kontinuierlich betrieben, indem durch Abscheidung im Durchmesser angewachsene Partikel aus dem Reaktor abgeführt und frische Siliciumkeimpartikel zudosiert werden.

Vorzugweise wird als siliciumhaltiges Reaktionsgas Trichlorsilan verwendet. Die Temperatur der Wirbelschicht im Reaktionsbereich beträgt in diesem Fall 850-1400°C.

Ebenso bevorzugt ist es, als siliciumhaltiges Reaktionsgas Monosilan einzusetzen. Die Temperatur der Wirbelschicht im Reaktionsbereich beträgt vorzugweise 550-850 °C.

Weiterhin ist es bevorzugt, als siliciumhaltiges Reaktionsgas Dichlorsilan einzusetzen. Die Temperatur der Wirbelschicht im Reaktionsbereich beträgt vorzugweise 600-1000 °C.

Beim Fluidisierungsgas handelt es sich vorzugsweise um Wasserstoff.

Das Reaktionsgas wird über eine oder mehrere Düsen in die Wirbelschicht eingedüst. Die lokalen Gasgeschwindigkeiten am Austritt der Düsen betragen vorzugsweise 0,5 bis 200 m/s.

Die Konzentration des siliciumhaltigen Reaktionsgases beträgt bezogen auf die gesamte durch die Wirbelschicht strömende Gasmenge vorzugsweise 5 mol-% bis 50 mol-%, besonders bevorzugt 15 mol-% bis 40 mol-%.

Die Konzentration des siliciumhaltigen Reaktionsgases in den Reaktionsgasdüsen beträgt bezogen auf die gesamte durch die Reaktionsgasdüsen strömende Gasmenge vorzugsweise 20 mol-% bis 80 mol-%, besonders bevorzugt 30 mol-% bis 60 mol-%. Als siliciumhaltiges Reaktionsgas kommt vorzugweise Trichlorsilan zum Einsatz.

Der Reaktordruck beträgt 0 bis 7,0 bar Überdruck, vorzugsweise 0,5 bis 4,5 bar Überdruck.

Bei einem Reaktor mit einem Durchmesser von z. B. 400 mm beträgt der Massenstrom an siliciumhaltigem Reaktionsgas vorzugsweise 200 bis 600 kg/h. Der Wasserstoffvolumenstrom beträgt vorzugsweise 100 bis 300 Nm³/h. Für größere Reaktoren sind höhere Mengen an siliciumhaltigem Reaktionsgas und H₂ bevorzugt.

Dem Fachmann ist klar, dass einige Prozessparameter idealerweise abhängig von der Reaktorgröße ausgewählt werden. Daher sind im Folgenden auf die Reaktorquerschnittsfläche normierte Betriebsdaten genannt, in denen das erfindungsgemäße Verfahren vorzugweise angewendet wird.

Der spezifische Massenstrom an siliciumhaltigem Reaktionsgas beträgt vorzugsweise 1600- 6500 kg/(h*m²).

Der spezifische Wasserstoffvolumenstrom beträgt vorzugsweise 800-4000 Nm³/(h*m²).

Das spezifische Bettgewicht beträgt vorzugsweise 700-2000 kg/m².

Die spezifische Siliciumkeimpartikeldosierrate beträgt vorzugsweise 7-25 kg/(h*m²).

Die spezifische Reaktorheizleistung beträgt vorzugsweise 800-3000 kW/m².

Die Verweilzeit des Reaktionsgases in der Wirbelschicht beträgt vorzugsweise 0,1 bis 10 s, besonders bevorzugt 0,2 bis 5 s.

### Kurzbeschreibung der Figur

**Fig. 1** zeigt den schematischen Aufbau eines montierten Wirbelschichtreaktors.

### Bezugszeichenliste

- **1**: Reaktorschuss
- **2**: Zwischenmantel
- **3**: Reaktionsraum
- **4**: Bodenplatte
- **5**: Reaktionsgasdüsen
- **6**: Fluidisierungsdüsen
- **7**: Untere Reaktorrohrdichtung
- **8**: Reaktorrohr
- **9**: Zylinderförmiges Bauteil
- **10**: Heizer
- **11**: Elektroden
- **12**: Isolation Heizbereich
- **13**: Isolation im nichtbeheizten Bereich
- **14**: Obere Reaktorrohreinspannung
- **15**: Obere Reaktorrohrdichtung
- **16**: Reaktorkopf
- **17**: Seedzufuhreinrichtung
- **18**: Abgasrohrleitung
- **19**: Messeinrichtungen
- **20**: Produktabzugsleitung
- **21**: Fluidisierungsgas-Zuführung
- **22**: Reaktionsgas-Zuführung

Der Wirbelschichtreaktor umfasst einen Reaktorschuss **1,** in den ein Reaktorrohr **8** eingesetzt ist und der nach oben durch den Reaktorkopf **16** und nach unten durch die Bodenplatte **4** begrenzt wird.

Zwischen einer Innenwand des Reaktorschusses **1** und der Außenwand des Reaktorrohrs **8** befindet sich ein Zwischenmantel **2.** Dieser Zwischenmantel **2** beinhaltet Heizer **10,** die mit Elektroden **11** verbunden sind, sowie Isolationsmaterial, nämlich Isolation **12** im Heizbereich und Isolation **13** im nichtbeheizten Bereich.

Der Zwischenmantel **2** wird mit einem Inertgas gefüllt bzw. wird mit einem Inertgas gespült. Der Druck im Zwischenmantel **2** kann höher sein als im Reaktionsraum **3,** der durch die Wandungen des Reaktorrohrs **8** begrenzt wird.

Im Inneren des Reaktorrohres **8** befindet sich die Wirbelschicht aus Polysilicium-Granulat.

Als Zugase werden dem Reaktor das Fluidisierungsgas über Fluidisierungsdüsen **6** und das Reaktionsgasgemisch über Reaktionsgasdüsen **5** zugeführt.

Die Höhe der Reaktionsgasdüsen **5** kann sich von der Höhe der Fluidisierungsdüsen **6** unterscheiden.

Über das Reaktorrohr **8** ist ein zylinderförmiges Bauteil **9** gestülpt, um bei bestimmten Reaktorkonstruktionen und Prozessen den Heizer beim Ausfahren zu schützen und die Temperatur zu vergleichmäßigen.

Der Reaktorkopf **16** kann einen größeren Querschnitt als die Wirbelschicht haben. Der Reaktorkopf **16** ist an der oberen Reaktorrohreinspannung **14** befestigt.

Über eine Seedzuführeinrichtung **17** wird dem Reaktor Seed am Reaktorkopf **16** zugeführt.

Das polykristalline Siliciumgranulat wird über eine Produktabzugsleitung **20** an der Bodenplatte **4** entnommen.

Am Reaktorkopf **16** wird das Reaktorabgas mittels Abgasrohrleitung **18** abgezogen.

Das Reaktorrohr **8** ist gegen die Bodenplatte **4** sowie gegen die obere Reaktorrohreinspannung **14** mittels Dichtungen, nämlich die untere Reaktorrohrdichtung **7** und die obere Reaktorrohrdichtung **15,** abgedichtet, so dass das Reaktorrohr gasdicht ist.

Weiterhin sind Messeinrichtungen **19** am Reaktorkopf **16** montiert. Mit den Messeinrichtungen **19** werden vorzugweise der Kopfreaktordruck sowie mittels eines Pyrometer durch ein Schauglas die Wirbelschicht-Temperatur gemessen. In einer Ausführungsform erfolgt eine Kameraaufzeichnung durch ein Schauglas.

## Patentansprüche

1. Verfahren zur Montage eines Wirbelschichtreaktors für die Herstellung von polykristallinem Siliciumgranulat, umfassend nachfolgende Schritte in der angegebenen Reihenfolge:
- Bodenplatte (4) aufbauen und mit Gaszufuhrleitungen für Fluidisierungsgas (21) und Reaktionsgas (22) und Produktabzugsleitung (20) verbinden;
- Bodenplatte (4) mit wenigstens einer Fluidisierungsdüse (6) und mit wenigstens einer Reaktionsgasdüse (5) bestücken;
- Untere Reaktorrohrdichtung (7) in die Bodenplatte (4) einsetzen;
- Reaktorrohr (8) auf untere Reaktorrohrdichtung (7) aufbauen;
- Aufstellen des Reaktorschusses (1) mit Heizer (10), Elektroden (11) und Isolationen (12, 13) über dem Reaktorrohr (8);
- Obere Reaktorrohreinspannung (14) mit oberer Reaktorrohrdichtung (15) aufbauen;
- Montage des Reaktorkopfes (16);
- Montage Seedzufuhreinrichtung (17) und Abgasrohrleitung (18).

## Claims

1. Method for assembling a fluidized bed reactor for producing polycrystalline silicon granules, comprising the steps hereinafter in the stated sequence:
- establish base plate (4) and connect to gas supply lines for fluidizing gas (21) and reaction gas (22) and product take-off line (20);
- equip base plate (4) with at least one fluidizing nozzle (6) and with at least one reaction gas nozzle (5) ;
- insert bottom reactor tube seal (7) into the base plate (4);
- establish reactor tube (8) on bottom reactor tube seal (7);
- position the reactor section (1) with heater (10), electrodes (11) and insulation sections (12, 13) over the reactor tube (8);
- establish upper reactor tube clamp (14) with upper reactor tube seal (15);
- assembly of the reactor head (16);
- assembly of seed feed appliance (17) and off-gas pipeline (18).

## Revendications

1. Procédé de montage d'un réacteur à lit fluidisé pour la préparation de granulat de silicium polycristallin, comprenant les étapes suivantes, dans l'ordre indiqué :
- la construction d'une plaque de base (4) et sa connexion à des conduites d'alimentation en gaz pour le gaz de fluidisation (21) et le gaz de réaction (22) et à une conduite d'évacuation de produit (20) ;
- le montage sur la plaque de base (4) d'au moins une buse de fluidisation (6) et d'au moins une buse de gaz de réaction (5) ;
- l'insertion d'un joint d'étanchéité de tube de réacteur inférieur (7) dans la plaque de base (4) ;
- la construction d'un tube de réacteur (8) sur le joint d'étanchéité de tube de réacteur inférieur (7) ;
- le positionnement de la section de réacteur (1) avec un dispositif de chauffage (10), des électrodes (11) et des isolations (12, 13) au-dessus du tube de réacteur (8) ;
- l'établissement du serrage du tube de réacteur supérieur (14) avec un joint d'étanchéité de tube de réacteur supérieur (15) ;
- le montage de la tête de réacteur (16) ;
- le montage du dispositif d'alimentation en granules (17) et de la conduite de gaz d'échappement (18).
